# EUROPÄISCHE PATENTSCHRIFT

(11) **EP 0 495 141 B1**
(45) Veröffentlichungstag und Bekanntmachung des Hinweises auf die Patenterteilung: **07.09.1994**
(21) Anmeldenummer: 91100468.7
(22) Anmeldetag: 16.01.1991
(51) Int. Cl.: H03G 3/20, H04N 5/52

(54) **Amplitudenregeleinrichtung**
Amplitude control circuit
Dispositif de réglage d'amplitude

(43) Veröffentlichungstag der Anmeldung: 22.07.1992
(73) Patentinhaber: SIEMENS AKTIENGESELLSCHAFT, 80333 München (DE)
(72) Erfinder: Heymann, Roland, W-8029 Sauerlach (DE)

(56) Entgegenhaltungen:
- US-A- 4 165 493
- US-A- 4 884 141
- POST OFFICE ELECTRICAL ENGINEERS JOURNAL. Bd. 62, Nr. 4, 1970, LONDON GB Seiten213 - 217; N. P. MCKAY: 'Wideband Signal-limiters '
- 'ICs für die Unterhaltungselektronik; Datenbuch 1990/91' , SIEMENS , DE,MüNCHEN
- PATENT ABSTRACTS OF JAPAN vol. 8, no. 264 (E-282)(1701) 4. Dezember 1984& JP-A-59 135 915 (MATSUSHITA ) 4. August 1984

## Beschreibung

Die Erfindung betrifft eine Amplitudenregeleinrichtung nach dem Oberbegriff des Anspruchs 1.

Amplitudenregeleinrichtungen dienen in Verstärkerschaltungen zum Konstanthalten von Ausgangssignalen, um Schwankungen in einem der Amplitudeneinrichtung zugeführten Eingangssignal auszugleichen. Solche Amplitudenregeleinrichtungen sind unter den Bezeichnungen "automatische Verstärkungsregelung" oder "AGC" (Automatic Gain Control) bekannt.

In Amplitudenregeleinrichtungen wird das Eingangssignal einem von einem Stellgrößensignal steuerbaren Stellglied zugeführt, über das das Ausgangssignal geregelt werden kann. Dazu wird das Ausgangssignal erfaßt und davon abhängig das Stellgrößensignal erzeugt. Hierfür ist bekannt, den Spitzenwert und/oder Mittelwert des Ausgangssignales zu erfassen.

Wenn ausschließlich die Spitzenwerte des Ausgangssignales erfaßt werden, kann die Amplitudenregeleinrichtung bei Signalüberhöhungen auf sehr kurze Ansprechzeiten und damit kleine Regelzeiten ausgelegt werden. Allerdings erfordert eine solche Amplitudenregeleinrichtung bei komplexen Signalen, wie dies beispielsweise Videosignale sind, beim Auftreten von Signalverkleinerungen lange Reaktionszeiten, um beabsichtigte Pegelsprünge im Eingangssignal nicht ungewollt auszuregeln. Damit müssen aber die Regelzeitkonstanten bei diesen Amplitudenregeleinrichtungen auf erheblich größere Werte als die längsten zu erwartenden gewollten Pegeländerungen des Eingangssignales ausgelegt werden. Dies führt zu einer in vielen Fällen nicht erwünschten langsamen Ausregelung von Amplitudenänderungen, die durch Störgrößen verursacht werden.

Wenn ausschließlich die Mittelwerte des Eingangssignales erfaßt werden, führt dies grundsätzlich bei Signalüberhöhungen zu ähnlichen Regelzeiten, wie bei der obenerwähnten Spitzenwertdetektion. Allerdings ist die Ausregelgenauigkeit bei komplexen Signalen mit veränderlichem Mittelwert schlecht.

Bei Videosignalen ändert sich der Mittelwert des Eingangssignales in Abhängigkeit von dessen Modulation. Eine Bildzeile mit hohem Weißanteil ergibt einen größeren Mittelwert als eine Bildzeile mit viel Schwarzanteil. Beim Regeln mit dem Mittelwert würde das Stellglied das Eingangssignal verstärken und gegebenenfalls die Bildröhre übersteuern. Beim Signal mit dem hohen Schwarzanteil dagegen herabregeln. Als Folge würde die Bildhelligkeit in unerwünschter Weise schwanken.

Um bei komplexen Signalen eine günstige Ansprechgeschwindigkeit und Regelgenauigkeit zu erreichen, ist es bekannt, sowohl die Spitzenwerte als auch die Mittelwerte des Ausgangssignales zu detektieren und abhängig davon dem Stellglied eine Stellgröße bereitzustellen. Im integrierten Schaltkreis TDA 5930 von Siemens, der beispielsweise im Siemens-Datenbuch "ICs für die Unterhaltungselektronik", Ausgabe 9.90, Bestellnr. B 111-B6041-XX 7400, auf den Seiten 610 bis 631 vorgestellt wird, ist sowohl eine Mittelwertals auch Spitzenwertsteuerung des Stellgliedes in der Amplituden Regeleinrichtung eines Video-ZF-Verstärkers vorgesehen. Die Spitzenwertdetektion wird dabei nur bei Signalüberhöhungen, die Mittelwertdetektion erst bei so starken Signaleinbrüchen ausgewertet, bei denen man sicher sein kann, daß diese tatsächlich von Störgrößen verursacht werden.

Es hat sich als problematisch erwiesen, daß die Regelgeschwindigkeit bei Signaleinbrüchen des Eingangssignales von der Größe des Signaleinbruches abhängig ist, da die Mittelwertdetektion davon linear abhängige Stellgrößen abgibt. Je kleiner der detektierte Mittelwert des Ausgangssignales ist, desto höher ist die Stellgröße und umgekehrt. Das führt dazu, daß der Mittelwert bei einer teilweisen Ausregelung wieder zunimmt und folglich die Ausregelgeschwindigkeit der Amplitudenregeleinrichtung sinkt. Eine Verstärkung der Stellgröße des Mittelwertdetektors ist wegen der Regelsystemstabilität oft nicht durchführbar.

Der Erfindung liegt die Aufgabe zugrunde, eine Amplitudenregeleinrichtung anzugeben, bei der die Regelgeschwindigkeit im Vergleich zu den bisher bekannten Amplitudenregeleinrichtungen erhöht ist. Zusätzlich sollte die neue Amplitudenregeleinrichtung ohne großen Aufwand in die bereits bekannten Regeleinrichtungen implementierbar sein.

Diese Aufgabe wird durch die kennzeichnenden Merkmale des Anspruchs 1 gelöst.

Weiterbildungen der Erfindung sind Gegenstand der Unteransprüche.

Die Erfindung wird im folgenden anhand von drei Figuren näher erläutert. Es zeigen:
- FIG 1: eine bekannte Amplitudenregeleinrichtung mit Spitzenwertregler und linearem Mittelwertregler, wie dieser beispielsweise im integrierten Schaltkreis TDA 5930 Verwendung findet,
- FIG 2: eine erfindungsgemäße Amplitudenregeleinrichtung mit einem Spitzenwertregler und einem schaltbaren Mittelwertregler mit Speichereinrichtung, und
- FIG 3: eine vereinfachte Schaltungsanordnung der Amplitudenregeleinrichtung von FIG 2.

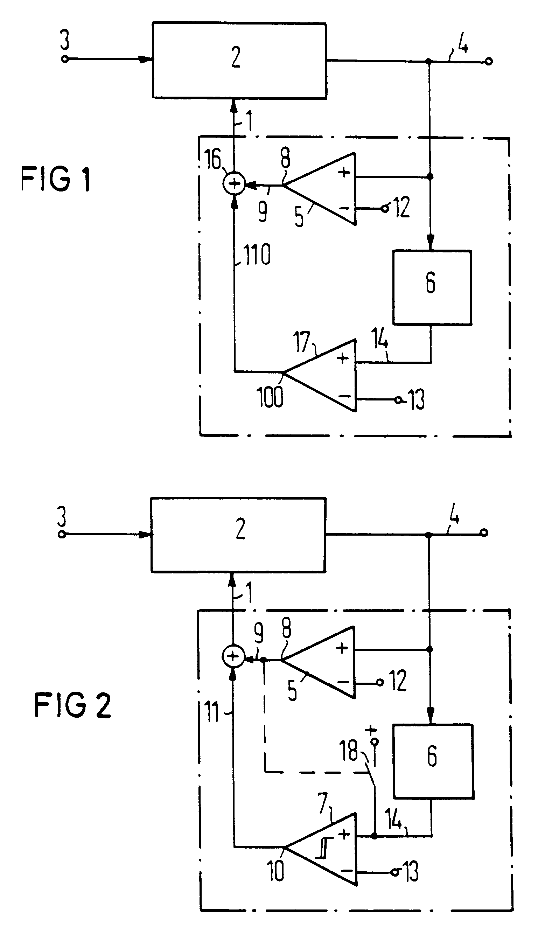

In FIG 1 ist eine bekannte Amplitudenregeleinrichtung dargestellt, wie diese beispielsweise im integrierten Schaltkreis TDA 5930 von Siemens verwendet wird. Die Amplitudenregeleinrichtung weist in diesem integrierten Schaltkreis, der einen Video-ZF-Verstärker enthält, ein von einem Stellgrößensignal 1 ansteuerbares Stellglied 2 auf, über das ein Eingangssignal 3 - hier ein Videosignal - geregelt werden kann, und zwar so, daß ein an einem Ausgang des Stellgliedes 2 abgreifbares Ausgangssignal 4 konstant gehalten wird.

Als Stellgrößensignal 1 dient beispielsweise eine Regelspannung, die sich aus zwei Anteilen zusammensetzt. Den ersten Anteil bildet eine Spitzenwertstellgröße 9, die an einer Ausgangsklemme 8 eines Spitzenwertreglers 5 abgreifbar ist. Dieser Spitzenwertregler ist im wesentlichen ein Differenzverstärker, dessen Pluseingangsklemme das Ausgangssignal 4 der Amplitudenregeleinrichtung zugeführt wird und dessen Minuseingangsklemme mit einem Spitzenreferenzwert 12 beaufschlagt ist. Erreicht oder überschreitet das Ausgangssignal 4 diesen Spitzenwertreferenzwert 12, so steht am Ausgang 8 des Spitzenwertreglers 5 eine Spitzenwertstellgröße 9 an, deren Wert von der Differenz der beiden am Spitzenwertregler 5 anstehenden Eingangssignale 4, 12 abhängt. Den zweiten Anteil bildet ein Mittelwertstellgrößensignal 110, das an einer Ausgangsklemme 100 eines Mittelwertreglers 17 abgreifbar ist. Als Eingangssignale werden diesem Mittelwertregler 17 ein Mittelwertreferenzwert 13 und ein Mittelwertsignal 14 zugeführt, wobei der Mittelwertreferenzwert 13 an die Minuseingangsklemme und das Mittelwertsignal 14 an die Pluseingangsklemme des Mittelwertreglers 17, der im wesentlichen ein Differenzverstärker ist, anzulegen sind. Das Mittelwertsignal 14 wird aus dem Ausgangssignal 4 der Amplitudenregeleinrichtung gewonnen, indem es durch eine Mittelwertbildungseinrichtung 6 geführt wird. In Abhängigkeit der Differenz vom Mittelwertreferenzwert 13 zum Mittelwertsignal 14 ergibt sich an der Ausgangsklemme 100 des Mittelwertreglers 17 eine Mittelwertstellgröße 11, die linear von der genannten Differenz abhängt. In einer Addiereinrichtung 16 wird ein Summensignal, das zugleich das Stellgrößensignal 1 ist, aus dem Mittelwertstellgrößensignal 11 und dem Spitzenwertstellgrößensignal 9, gebildet.

Eine erfindungsgemäße Amplitudenregeleinrichtung zeigt FIG 2 im Blockschaltbild. Die bereits bekannten Bezugszeichen werden für gleiche Teile weiterverwendet. Im Gegensatz zur bekannten Amplitudenregeleinrichtung von FIG 1 wird jetzt ein Mittelwertregler 7 mit einer Speichereinrichtung zum Speichern eines fest vorgegebenen Mittelwertstellgrößensignales 11 vorgesehen. Dieses Mittelwertstellgrößensignal 11 wird dann an die Ausgangsklemme 10 des Mittelwertreglers 7 geschaltet, wenn das Mittelwertsignal 14 den vorgegebenen Mittelwertreferenzwert 13 unterschreitet. Der vorgegebene Mittelwertreferenzwert 13 ist von der Regelsystemstabilität der Amplitudenregeleinrichtung abhängig. Das Mittelwertstellgrößensignal 11 ist jedoch ausschaltbar und nimmt damit den Wert 0 an, wenn das Mittelwertreferenzpotential 13 vom Mittelwertsignal 14 wieder überschritten wird. Um ein stabiles Schalten am Ausgang des Mittelwertreglers 7 zu gewährleisten, ist die Verwendung einer Schalthysterese im Mittelwertregler 7 vorzusehen. Für Analogschaltungsanordnungen hat sich wegen des dort geringen Bauteileaufwandes die Verwendung eines Schmitt-Triggers, also eines Differenzverstärkers mit Schalthysterese, als vorteilhaft für den Einsatz eines Mittelwertreglers 7 mit geschaltetem Ausgang erwiesen. In Digitalschaltungsanordnungen ist für den Mittelwertregler 7 auch die Verwendung eines Mono-Flops oder Flip-Flops möglich.

Um eine optimale Regelgeschwindigkeit der Amplitudenregeleinrichtung zu erreichen, ist es möglich, neben der Abschaltung des Mittelwertstellgrößensignales 11 durch Vergleich des Mittelwertsignales 14 mit dem Mittelwertreferenzwert 13 auch eine Abschaltung des Mittelwertstellgrößensignales 11 dann zu bewirken, wenn der Spitzenwert des Ausgangssignales 4 den Spitzenwertreferenzwert 12 überschreitet. Dies ist in FIG 2 schematisch durch die am Pluseingang des Mittelwertreglers 7 angeordnete Schalteinrichtung 18 angedeutet, die vom Spitzenwertstellgrößensignal 9 steuerbar ist. Die Schalteinrichtung 18 ist zwischen den Pluseingang einer Spannungsquelle und den Pluseingang des Mittelwertreglers 7 geschaltet. Eine solche Kombination der Abschaltung durch Mittelwert und Spitzenwert des Mittelwertstellgrößensignales 11 hat sich als zweckmäßig erwiesen, da sonst bei zu regelnden Signalen mit sehr geringen Mittelwerten aber hohen Spitzenwerten zwar die Einschaltschwelle beim Mittelwertregler erreicht wird, aber niemals deren Ausschaltschwelle. Die Folge wäre eine Störung des Regelsystems.

Mit der erfindungsgemäßen Amplitudenregeleinrichtung wird somit eine Mittelwertabschaltung und eine Spitzenwertabschaltung des Mittelwertstellgrößensignales 11 erreicht, wobei die Mittelwertabschaltung wegen ihrer großen Zeitkonstanten eine gute Systemstabilität und die Spitzenwertabschaltung hinsichtlich der Mittelwertstellgrößenabschaltung eine gute Sicherheit bietet.

Ergebnis dieser erfindungsgemäßen Kombination der Mittelwertabschaltung und Spitzenwertabschaltung des Mittelwertstellgrößensignales 11 ist, daß die Regelgeschwindigkeit bei Signaleinbrüchen des zu regelnden Ausgangssignales weitgehend unabhängig von der Größe eines Signaleinbruchs im Eingangssignal ist. Die Regelgeschwindigkeit ist im Vergleich zum eingangs erwähnten Stand der Technik höher.

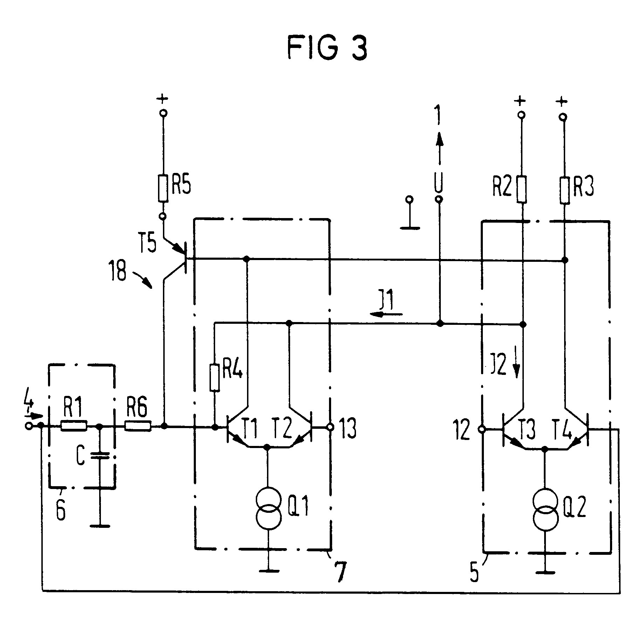

FIG 3 zeigt ein Beispiel für eine prinzipielle analoge Schaltungsanordnung zur Erzeugung des Stellgrößensignales 1 in Form einer Stellspannung U. Die Schaltungsanordnung weist im wesentlichen zwei jeweils von einer Stromquelle Q1, Q2 gespeiste Differenzverstärker mit den Transistoren T1, T2 sowie T3, T4 auf, deren Emitteranschlüsse über die Stromquellen Q1 bzw. Q2 auf Bezugspotential gelegt sind. Der Kollektoranschluß des Transistors T1 ist mit dem Kollektoranschluß des Transistors T4 und der Kollektoranschluß des Transistors T2 mit dem Kollektoranschluß T3 verbunden und über jeweils einen Widerstand R2, R3 an eine positive Spannung angeschlossen. Um eine Schalthysterese zu erreichen, ist der Kollektor des Transistors T2 über einen Widerstand R4 über einen Widerstand R4 mit der Basis des Transistors T1 verbunden, wodurch eine Mitkopplung, wie diese für eine Schalthysterese notwendig ist, erreicht wird. Dem Differenzverstärker mit den Transistoren T1, T2, der dem in FIG 2 dargestellten Mittelwertregler 7 entspricht, wird der durch eine Mittelwertbildungseinrichtung 6 gebildete Mittelwert des Ausgangssignales 4 zugeführt, indem der Basisanschluß des Transistors T1 über einen Widerstand R6 mit dem Ausgang der Mittelwertbildungseinrichtung 6 verbunden ist. Der Mittelwertreferenzwert 13 ist an den Basisanschluß des Transistors T2 zu legen. Als Mittelwertbildungseinrichtung 6 dient im einfachsten Fall ein Tiefpaß, bestehend aus dem Widerstand R1 und dem auf Bezugspotential geschalteten Kondensator C, so wie in FIG 3 dargestellt.

Der zweite dem Spitzenwertregler 5 von FIG 2 entsprechenden Differenzverstärker mit den Transistoren T3 und T4 erhält als Eingangssignale zum einen an der Basis des Transistors T4 das Ausgangssignal 4 (vgl. FIG 2) und am Basisanschluß des Transistors T3 den Spitzenwertreferenzwert 12.

Zusätzlich weist die Schaltungsanordnung eine Schalteinrichtung zum Abschalten des Mittelwertstellgrößensignales 11 auf. Diese Schalteinrichtung besteht aus einem pnp-Transistors T5, dessen Basisanschluß mit den Kollektoranschlüssen der Differenzverstärkertransistoren T1 und T4 verbunden ist und dessen Kollektoranschluß mit dem Basisanschluß des Transistors T1 des ersten Differenzverstärkers T1, T2 verbunden und dessen Emitteranschluß über einen Widerstand R5 an eine positive Spannung gelegt ist. Die Schalteinrichtung könnte auch einen an den Basisanschluß des Transistors T2 mit seinem Kollektoranschluß geschalteten npn-Transistors aufweisen, dessen Emitteranschluß auf Bezugspotential liegt und dessen Basisanschluß mit den Kollektoranschlüssen der Differenzverstärkertransistoren T2 und T3 verbunden ist. Wird das Stellgrößensignal 1, das als Regelspannung U zwischen den Kollektoranschlüssen der Differenzverstärkertransistoren T2 bzw. T3 und Bezugspotential abgreifbar ist, groß, schaltet der Transistor T5 ein und steuert den Transistor T1 voll durch. Ergebnis ist, daß der Ausgangsstrom I1, der das Mittelwertstellgrößensignal bildet, des ersten Differenzverstärkers T1, T2 - wie gefordert - Null und damit abgeschaltet wird. Das Stellgrößensignal 1 ist dann nur noch vom Ausgangsstrom I2 des zweiten Differenzverstärkers T3, T4 abhängig. Das Stellgrößensignal 1 ist, wie erwähnt, am Kollektoranschluß des Transistors T3 bezogen auf Bezugspotential abgreifbar.

Als besonders vorteilhaft hat sich bei der erfindungsgemäßen Amplitudenregeleinrichtung von FIG 3 der Umstand erwiesen, daß diese in einfacher Weise in die bekannte Amplitudenregeleinrichtung des integrierten Schaltkreises TDA 5930 implementierbar ist. Im wesentlichen müssen nämlich nur die Widerstände R4, R6 die für die Schalthysterese des Differenzverstärkers T1, T2 notwendige Mitkopplung bewirken, und der Schalttransistor T5 als zusätzlich Schaltelemente aufgenommen werden, da die Mittelwertbildungseinrichtung 6 und die beiden Differenzverstärker T1, T2 und T3, T4 bereits im TDA 5930 enthalten sind.

## Patentansprüche

1. Amplitudenregeleinrichtung mit einem von einem Stellgrößensignal (1) steuerbaren Stellglied (2) zum Regeln eines von einem Eingangssignal (3) abzuleitenden Ausgangssignales (4), wobei das Ausgangssignal (4) einem Spitzenwertregler (5) zuführbar ist und über eine Mittelwertbildungseinrichtung (6), durch die ein Mittelwertsignal (14) bereitstellbar ist, einem Mittelwertregler (7) zuführbar ist und sich das Stellgrößensignal (1) als Summensignal eines an einer Ausgangsklemme (8) des Spitzenwertreglers (5) abgreifbaren Spitzenwertstellgrößensignales (9) und eines an einer Ausgangklemme (10) des Mittelwertreglers (7) abgreifbaren Mittelwertstellgrößensignales (11) zusammensetzt,
**dadurch** **gekennzeichnet**,
daß im Mittelwertregler (7) ein fest vorgegebenes Mittelwertstellgrößensignal (11) gespeichert ist, daß dieses Mittelwertstellgrößensignal (11) an die Ausgangsklemme (10) des Mittelwertreglers (7) schaltbar ist, wenn das Mittelwertsignal (14) einen vorgegebenen Mittelwertreferenzwert (13) unterschreitet, und daß das Mittelwertstellgrößensignal (11) abschaltbar ist, wenn das vorgegebene Mittelwertreferenzpotential (13) vom Mittelwertsignal (14) überschritten wird.

2. Amplitudenregeleinrichtung nach Anspruch 1,
**dadurch** **gekennzeichnet**,
daß das Mittelwertstellgrößensignal (11) abschaltbar ist, wenn das Ausgangssignal (4) ein im Spitzenwertregler (5) vorgegebenes Spitzenreferenzsignal (12) überschreitet.

3. Amplitudenregeleinrichtung nach Anspruch 1 oder 2,
**dadurch** **gekennzeichnet**,
daß der Mittelwertregler (7) einen emittergekoppelten Differenzverstärker mit Hysterese aufweist.

4. Verwendung der Amplitudenregeleinrichtung nach einem der Ansprüche 1 bis 3 in einer Schaltungsanordnung zur Zwischenfrequenzverstärkung von Videosignalen.

## Claims

1. Amplitude regulating device having an actuating element (2), which can be controlled by a control variable signal (1), for regulating an output signal (4) which is to be derived from an input signal (3), it being possible to supply the output signal (4) to a peak-value regulator (5) and, via an averaging device (6) by means of which an average signal (14) can be provided, to an average regulator (7), and the control variable signal (1) being composed of the sum signal of a peak value control variable signal (9) which can be picked off on an output terminal (8) of the peak-value regulator (5), and of an average control variable signal (11) which can be picked off on an output terminal (10) of the average regulator (7), characterized in that a fixedly predetermined average control variable signal (11) is stored in the average regulator (7), in that this average control variable signal (11) can be connected to the output terminal (10) of the average regulator (7) when the average signal (14) is less than a predetermined average reference value (13), and in that the average control variable signal (11) can be switched off when the predetermined average reference potential (13) is exceeded by the average signal (14).

2. Amplitude regulating device according to Claim 1, characterized in that the average control variable signal (11) can be switched off when the output signal (4) exceeds a peak reference signal (12) which is predetermined in the peak-value regulator (5).

3. Amplitude regulating device according to Claim 1 or 2, characterized in that the average regulator (7) has an emitter-coupled differential amplifier with hysteresis.

4. Use of the amplitude regulating device according to one of Claims 1 to 3 in a circuit arrangement for intermediate-frequency amplification of video signals.

## Revendications

1. Dispositif de régulation d'amplitude comportant un circuit de réglage (2) commandable par un signal de grandeur de réglage (1) et servant à régler un signal de sortie (4) devant être dérivé d'un signal d'entrée (3), et dans lequel le signal de sortie (4) peut être envoyé à un régulateur de valeurs crêtes (5) et peut être envoyé, par l'intermédiaire d'un dispositif de formation de valeur moyenne (6), qui peut délivrer un signal de valeur moyenne (14), à un régulateur (7) de la valeur moyenne, et le signal de grandeur de réglage (1) est constitué par un signal somme formé par la réunion d'un signal de grandeur de réglage de valeur crête (9), qui peut être prélevé sur une borne de sortie (8) du régulateur de valeurs crêtes (5), et par un signal de grandeur de réglage de valeur moyenne (11) qui peut être prélevé sur une borne de sortie (10) du régulateur (7) de la valeur moyenne, caractérisé par le fait
qu'un signal de grandeur de réglage de valeur moyenne (11), prédéterminé de façon fixe, est mémorisé dans le régulateur (7) de la valeur moyenne, que ce signal de grandeur de réglage de valeur moyenne (11) peut être appliqué à la borne de sortie (10) du régulateur (7) de la valeur moyenne, lorsque le signal de valeur moyenne (14) tombe au-dessous d'une valeur prédéterminée de référence de valeur moyenne (13), et qu'un signal de grandeur de réglage de valeur moyenne (11) peut être interrompu lorsque le signal de valeur moyenne (14) dépasse le potentiel prédéterminé de référence de valeur moyenne (13).

2. Dispositif de régulation d'amplitude suivant la revendication 1, caractérisé par le fait que le signal de grandeur de réglage de valeur moyenne (11) peut être interrompu lorsque le signal de sortie (4) dépasse un signal de référence maximum (12) prédéterminé dans le régulateur de valeurs crêtes (5).

3. Dispositif de régulation d'amplitude suivant la revendication 1 ou 2, caractérisé par le fait que le régulateur (7) de la valeur moyenne possède un amplificateur différentiel à émetteurs couplés, présentant une hystérésis.

4. Utilisation du dispositif de régulation d'amplitude suivant l'une des revendications 1 à 3 dans un montage pour amplifier la fréquence intermédiaire de signaux vidéo.
